# EUROPÄISCHE PATENTANMELDUNG

(11) **EP 3 926 670 A1**
(43) Veröffentlichungstag der Anmeldung: **22.12.2021**
(21) Anmeldenummer: 20179978.0
(22) Anmeldetag: 15.06.2020
(51) Int. Cl.: H01L 23/373, H01L 23/00, H01L 25/07

(54) **LEISTUNGSHALBLEITERMODUL MIT ZUMINDEST EINEM LEISTUNGSHALBLEITERELEMENT**

(71) Anmelder: Siemens Aktiengesellschaft, 80333 München (DE)
(72) Erfinder: Radüge, Christian, 90425 Nürnberg (DE); Wagner, Claus Florian, 90425 Nürnberg (DE); Woiton, Michael, 90425 Nürnberg (DE)

(57) **Zusammenfassung**

Die Erfindung betrifft ein Leistungshalbleitermodul (2) mit zumindest einem Leistungshalbleiterelement (4). Um den erforderlichen Bauraum des Leistungshalbleitermoduls (2) zu verringern und dessen Lebensdauer zu erhöhen, wird vorgeschlagen, dass das zumindest eine Leistungshalbleiterelement (4) über eine dielektrische Materiallage (8) mit einem Kühlelement (10) in einer elektrisch isolierenden und thermisch leitfähigen Verbindung steht, wobei die dielektrische Materiallage (8) flächig auf einer Oberfläche (11) des Kühlelements (10) aufliegt und mittels einer orthogonal zur Oberfläche (11) des Kühlelements (10) wirkenden ersten Kraft (F1) kraftschlüssig mit dem Kühlelement (10) verbunden ist.

## Beschreibung

Die Erfindung betrifft ein Leistungshalbleitermodul mit zumindest einem Leistungshalbleiterelement.

Ferner betrifft die Erfindung einen Stromrichter mit mindestens einem derartigen Leistungshalbleitermodul.

Darüber hinaus betrifft die Erfindung ein Verfahren zur Herstellung eines derartigen Leistungshalbleitermoduls.

In Stromrichtern werden üblicherweise Leistungshalbleitermodule eingesetzt, die Keramik-Substrate mit beidseitiger Metallisierung aufweisen, wobei die Keramik-Substrate in der Regel über die Metallisierung auf einen metallischen Kühlkörper, der beispielsweise als Bodenplatte ausgeführt ist, gelötet sind. Unter einem Stromrichter ist beispielsweise ein Gleichrichter, ein Wechselrichter, ein Umrichter oder ein Gleichspannungswandler zu verstehen. Die Keramik-Substrate sind aufbaubedingt mit starkem intrinsischem Stress beaufschlagt, wobei die starre Lötverbindung zum Kühlkörper für zusätzlichen, insbesondere mechanischen und/oder thermo-mechanischen, Stress sorgt. Die in den Leistungshalbleitermodulen verwendeten Leistungshalbleiterelemente, die beispielsweise einen Transistor, insbesondere einen IGBT (Insulated-Gate Bipolar Transistor), umfassen, werden üblicherweise auf die Metallisierung des Keramik-Substrats aufgelötet. Daher weist der Gesamtaufbau sehr unterschiedliche thermische Ausdehnungskoeffizienten auf, wodurch die im Betrieb auftretenden thermischen Wechselbelastungen zusätzlichen, insbesondere mechanischen und/oder thermo-mechanischen, Stress hervorrufen.

Um die, insbesondere mechanischen und/oder thermo-mechanischen, Stressfaktoren zu kompensieren, wird das Keramik-Substrat dicker ausgeführt als es für die elektrische Isolationswirkung erforderlich ist, wodurch ein thermischer Widerstand zwischen den Leistungshalbleiterelementen und dem Kühlkörper steigt. Folglich sind Leistungshalbleiter mit größerer Chipfläche erforderlich, um die applikationsspezifischen Anforderungen aufgrund des höheren thermischen Widerstandes zu erfüllen. Darüber hinaus altern die starren Lotverbindungen, was zu einem vorzeitigen, insbesondere thermischen, Ausfall führt. Um thermische Hübe zu verkleinern und die erforderliche Lebensdauer dennoch zu erreichen, sind Leistungshalbleiter mit noch größerer Chipfläche erforderlich. Somit stellen mit zunehmender Miniaturisierung von Leistungshalbleitermodulen der Bauraum, die Lebensdauer und die Kosten eine große Herausforderung dar.

Die Offenlegungsschrift EP 0 762 496 A2 beschreibt ein Leistungshalbleitermodul, bei welchem mindestens ein Halbleiterchip, welcher auf einer Grundplatte angebracht ist, von je einem Kontaktstempel kontaktiert wird. Die Lage der Kontaktstempel ist entsprechend einem Abstand von den Halbleiterchips zu einem die Kontaktstempel aufnehmenden Hauptanschluss individuell einstellbar. Die Kontaktstempel werden entweder mittels einer Feder mit Druck beaufschlagt oder mittels einer Lotschicht fixiert.

Vor diesem Hintergrund ist es eine Aufgabe der vorliegenden Erfindung, den erforderlichen Bauraum von Leistungshalbleitermodulen weiter zu verringern und die Lebensdauer zu erhöhen.

Die Aufgabe wird erfindungsgemäß gelöst durch ein Leistungshalbleitermodul mit zumindest einem Leistungshalbleiterelement, wobei das zumindest eine Leistungshalbleiterelement über eine dielektrische Materiallage mit einem Kühlelement in einer elektrisch isolierenden und thermisch leitfähigen Verbindung steht, wobei die dielektrische Materiallage flächig auf einer Oberfläche des Kühlelements aufliegt und mittels einer orthogonal zur Oberfläche des Kühlelements wirkenden ersten Kraft kraftschlüssig mit dem Kühlelement verbunden ist.

Ferner wird die Aufgabe erfindungsgemäß durch einen Stromrichter mit zumindest einem derartigen Leistungshalbleitermodul gelöst.

Darüber hinaus wird die Aufgabe erfindungsgemäß durch ein Verfahren zur Herstellung eines derartigen Leistungshalbleitermoduls gelöst, wobei die dielektrische Materiallage flächig mit der Oberfläche des Kühlelements kontaktiert wird, wobei das Leistungshalbleiterelement auf der dielektrischen Materiallage kontaktiert wird und wobei mittels der orthogonal zur Oberfläche des Kühlelements wirkenden ersten Kraft eine kraftschlüssige Verbindung zum Kühlelement hergestellt wird.

Die in Bezug auf das Leistungshalbleitermodul nachstehend angeführten Vorteile und bevorzugten Ausgestaltungen lassen sich sinngemäß auf den Stromrichter und das Verfahren übertragen.

Der Erfindung liegt die Überlegung zugrunde, den mechanischen und/oder thermo-mechanischen Stress in einem Leistungshalbleitermodul zu verringern und den benötigten Bauraum zu reduzieren, indem eine elektrisch isolierende und thermisch leitfähige Verbindung zwischen einem Leistungshalbleiterelement und einem Kühlelement des Leistungshalbleitermoduls über eine dielektrische Materiallage hergestellt wird, wobei die dielektrische Materiallage kraftschlüssig mit einer Oberfläche des Kühlelements verbunden wird. Das Leistungshalbleitermodul umfasst mindestens einen, insbesondere abschaltbaren vertikalen, Leistungshalbleiter, sowie Verbindungsmittel zur Kontaktierung des, insbesondere abschaltbaren vertikalen, Leistungshalbleiters. Verbindungsmittel sind beispielsweise flächige Kontaktierungselemente, die aus einem metallischen Werkstoff hergestellt sind und dafür konfiguriert sind eine elektrische und/oder mechanische Verbindung zu einem Leiter, beispielsweise einem Bonddraht, oder zu einem Isolator, beispielsweise einer dielektrischen Materiallage, herzustellen. Der Leistungshalbleiter ist insbesondere als ein Transistor und/oder eine Diode, ausgeführt, wobei der Transistor beispielsweise als Insulated-Gate-Bipolar-Transistor (IGBT), als Metalloxide-Semiconductor-Field-Effect-Transistor (MOSFET) oder als ein Feldeffekttransistor ausgeführt ist. Insbesondere umfasst das Leistungshalbleiterelement genau einen Transistor und/oder genau eine Diode, sodass beispielsweise eine Halbbrücke aus zwei Leistungshalbleiterelementen ausbildbar ist.

Die dielektrische Materiallage ist aus einem keramischen Werkstoff, beispielsweise Aluminiumnitrid oder Aluminiumoxid, oder einem organischen Werkstoff, beispielsweise einem Polyamid, hergestellt. Durch den Wegfall der starren Verbindung zum Kühlkörper ist keine Metallisierung der dielektrischen Materiallage erforderlich, was die Kosten verringert. Beispielsweise beträgt eine Dicke d der dielektrischen Materiallage 25 µm bis 400 µm, insbesondere 50 µm bis 250 µm. Das Kühlelement ist beispielsweise als Kühlkörper ausgeführt, der Aluminium, Kupfer und/oder deren Legierungen enthält. Die dielektrische Materiallage liegt hierbei flächig auf der Oberfläche des Kühlelements auf. Die kraftschlüssige Verbindung wird mittels einer orthogonal zur Oberfläche des Kühlelements wirkenden ersten Kraft hergestellt, wobei die erste Kraft beispielsweise von einem Gehäusedeckel auf das Leistungshalbleiterelement übertragen wird. Durch den Wegfall der starren Verbindung zum Kühlkörper wird der, insbesondere mechanische und/oder thermo-mechanische, Stress im Leistungshalbleitermodul signifikant reduziert, was eine dünnere Ausführung der dielektrischen Materiallage ermöglicht und zu einer höheren Lebensdauer führt.

Eine weitere Ausführungsform sieht vor, dass die dielektrische Materiallage unmittelbar oder mittels Wärmeleitpaste schwimmend auf dem Kühlelement kontaktiert ist. Insbesondere wird die Wärmeleitpaste möglichst dünn aufgetragen, um einen möglichst geringen thermischen Widerstand zu erreichen. Beispielsweise wird eine Wärmeleitpaste verwendet, die sehr kleine Partikel, insbesondere mit einer Partikelgröße im Bereich von 0,04 µm bis 4 µm aufweist. Durch den schwimmenden Aufbau ist der mechanische und/oder thermische Stress für die dielektrische Materiallage signifikant reduziert, was dazu führt, dass die Keramik dünner ausbildbar ist, wodurch sich der thermische Widerstand zusätzlich reduziert. Ferner wird eine höhere Lebensdauer für das Leistungshalbleitermodul erreicht. Eine unmittelbare Kontaktierung schließt in diesem Zusammenhang zusätzliche Verbindungsmittel wie Kleber, Wärmeleitpaste, ... aus. Durch eine unmittelbare Kontaktierung wird eine geringere Bauteilhöhe erreicht, wobei bei einer unmittelbaren Kontaktierung der auf die dielektrische Materiallage wirkende Stress, insbesondere im Vergleich zu einer starren Lötverbindung, signifikant reduziert wird.

Eine weitere Ausführungsform sieht vor, dass die erste Kraft über eine erste Stromschiene auf das Leistungshalbleiterelement übertragen wird. Eine derartige Stromschiene wird auch Busbar genannt und wird beispielsweise aus Kupfer hergestellt. Insbesondere ist die Stromschiene im Wesentlichen senkrecht auf dem Leistungshalbleiterelement angeordnet, wodurch keine elektrischen Feldlinien im Leistungshalbleiterelement verändert werden, was sich positiv auf die elektrischen Eigenschaften während des Betriebes auswirkt. Eine derartige Stromschiene weist, insbesondere im Vergleich zu einen Bondverbindung, eine verbessere Zuverlässigkeit und eine höhere Lebensdauer auf. Da sowohl Kraftübertragung als auch elektrische Verbindung über die Stromschiene erfolgen, ist kein zusätzliches Bauteil erforderlich, wodurch Bauraum und Kosten eingespart werden.

Eine weitere Ausführungsform sieht vor, dass die dielektrische Materiallage eine adhäsive Verbindung zwischen dem Leistungshalbleiterelement und der Oberfläche des Kühlelements herstellt. Eine derartige adhäsive Verbindung ist beispielsweise über eine dielektrische Materiallage, die einen organischen Werkstoff, beispielsweise ein Polyamid enthält, herstellbar. Durch eine adhäsive Verbindung zusätzlich zur kraftschlüssigen Verbindung werden eine verbessere Zuverlässigkeit und eine höhere Lebensdauer des Leistungshalbleitermoduls erreicht.

Eine weitere Ausführungsform sieht vor, dass das Leistungshalbleitermodul mindestens zwei Leistungshalbleiterelemente aufweist, wobei jedem der mindestens zwei Leistungshalbleiterelemente eine dedizierte dielektrische Materiallage zugewiesen ist. Beispielsweise wird eine Halbbrücke aus zwei Leistungshalbleiterelementen ausgebildet, wobei jedem der zwei Leistungshalbleiterelemente der Halbbrücke eine dedizierte dielektrische Materiallage zugewiesen ist. Insbesondere bei sehr dünnen dielektrischen Materiallagen, die beispielsweise eine Dicke von maximal 400 µm aufweisen, wird der intrinsische Stress bei separaten dielektrischen Materiallagen deutlich reduziert.

Eine weitere Ausführungsform sieht vor, dass das Leistungshalbleiterelement einen Leistungshalbleiter aufweist, der auf einer der dielektrische Materiallage zugewandten Seite stoffschlüssig mit einem ersten metallischen Kontaktierungselement verbunden ist, wobei das Leistungshalbleiterelement über das erste metallische Kontaktierungselement auf der dielektrischen Materiallage aufliegt und durch die erste Kraft kraftschlüssig mit der dielektrischen Materiallage verbunden ist. Das erste metallischen Kontaktierungselement ist beispielsweise als Kupferplättchen oder Molybdänplättchen ausgeführt, das eine Dicke von 25 µm bis 250 µm aufweist. Die stoffschlüssige Verbindung wird beispielsweise durch Löten oder Sintern hergestellt. Durch ein derartiges metallisches Kontaktierungselement wird durch Spreizung der abzuführenden Wärme der thermische Widerstand bei im Wesentlichen gleichbleibender elektrischer Isolationswirkung reduziert.

Eine weitere Ausführungsform sieht vor, dass das erste metallische Kontaktierungselement unmittelbar oder mittels Wärmeleitpaste schwimmend auf der dielektrischen Materiallage kontaktiert ist. Insbesondere wird die Wärmeleitpaste möglichst dünn aufgetragen, um einen möglichst geringen thermischen Widerstand zu erreichen. Beispielsweise wird eine Wärmeleitpaste verwendet, die sehr kleine Partikel, insbesondere mit einer Partikelgröße im Bereich von 0,04 µm bis 4 µm aufweist. Durch den schwimmenden Aufbau ist der mechanische und/oder thermo-mechanische Stress für die dielektrische Materiallage signifikant reduziert, was dazu führt, dass die Keramik dünner ausbildbar ist, wodurch sich der thermische Widerstand zusätzlich reduziert. Ferner wird eine höhere Lebensdauer für das Leistungshalbleitermodul erreicht. Eine unmittelbare Kontaktierung schließt auch in diesem Zusammenhang zusätzliche Verbindungsmittel wie Kleber, Wärmeleitpaste, ... aus. Durch eine unmittelbare Kontaktierung wird eine geringere Bauteilhöhe erreicht, wobei bei einer unmittelbaren Kontaktierung der auf die dielektrische Materiallage wirkende Stress, insbesondere im Vergleich zu einer starren Lötverbindung, signifikant reduziert wird.

Eine weitere Ausführungsform sieht vor, dass zumindest ein zweites metallisches Kontaktierungselement auf einer der dielektrischen Materiallage abgewandten Seite des Leistungshalbleiters flächig mit dem Leistungshalbleiter verbunden ist, wobei die erste Stromschiene unmittelbar mit dem zweiten metallischen Kontaktierungselement kontaktiert ist, wobei die erste Kraft über die erste Stromschiene auf das zweite metallische Kontaktierungselement wirkt. Das zweite metallische Kontaktierungselement ist beispielsweise als Kupferplättchen oder Molybdänplättchen ausgeführt, das eine Dicke von 25 µm bis 250 µm aufweist, und schützt den Leistungshalbleiter vor mechanischer Beschädigung oder Zerstörung durch die erste Stromschiene.

Eine weitere Ausführungsform sieht vor, dass das zweite metallische Kontaktierungselement stoffschlüssig mit dem Leistungshalbleiter verbunden ist. Eine derartige stoffschlüssige Verbindung wird beispielsweise über Löten oder Sintern hergestellt. Durch die stoffschlüssige Verbindung wird eine optimale elektrische und thermische Anbindung des Kontaktierungselements an das Leistungshalbleiterelement erreicht.

Eine weitere Ausführungsform sieht vor, dass die erste Stromschiene kraftschlüssig mit dem zweiten metallischen Kontaktierungselement verbunden ist. Beispielsweise wird die erste Stromschiene über einen Gehäusedeckel auf das zweite metallische Kontaktierungselement gedrückt und so eine thermisch und elektrisch leitfähige Verbindung hergestellt. Eine derartige Verbindung ist lösbar und einfach zu fertigen.

Eine weitere Ausführungsform sieht vor, dass ein Steuerkontakt, insbesondere ein Gate-Kontakt, des Leistungshalbleiters, insbesondere über eine Bondverbindung, mit einem dritten metallischen Kontaktierungselement verbunden ist, wobei das dritte metallische Kontaktierungselement mittels einer orthogonal zur Oberfläche des Kühlelements wirkenden zweiten Kraft kraftschlüssig mit dem Kühlelement verbunden ist. Da derartige Steuerkontakte wie der Gate-Kontakt eines IGBTs, insbesondere im Vergleich zu einem stromführenden Emitter-Kontakt oder Kollektor-Kontakt, eine sehr viel kleinere Fläche aufweisen, werden diese, aus Kostengründen und um die Herstellung zu vereinfachen, über eine konventionelle Bondverbindung erzeugt. Das dritte metallische Kontaktierungselement ist insbesondere als Kupferplättchen oder Molybdänplättchen ausgeführt, das eine Dicke von 25 µm bis 250 µm aufweist, und ermöglicht beispielsweise eine kurze Bonddrahtlänge.

Eine weitere Ausführungsform sieht vor, dass die zweite Kraft über eine zweite Stromschiene auf das dritte metallische Kontaktierungselement wirkt. Die Stromschiene ist beispielsweise aus Kupfer hergestellt. Insbesondere ist die Stromschiene im Wesentlichen senkrecht auf dem dritten metallischen Kontaktierungselement angeordnet, was sich positiv auf die elektrischen Eigenschaften während des Betriebes auswirkt. Eine derartige Stromschiene weist, insbesondere im Vergleich zu einen Bondverbindung, eine verbessere Zuverlässigkeit und eine höhere Lebensdauer auf. Da sowohl Kraftübertragung als auch elektrische Verbindung über die Stromschiene erfolgen, ist kein zusätzliches Bauteil erforderlich, wodurch Bauraum und Kosten eingespart werden.

Eine weitere Ausführungsform sieht vor, dass das Leistungshalbleiterelement durch Herstellung einer stoffschlüssigen Verbindung des Leistungshalbleiters mit einem Leadframe gebildet wird, wobei der Leadframe das erste metallische Kontaktierungselement und das dritte metallische Kontaktierungselement, welches mit dem ersten metallischen Kontaktierungselement verbunden ist, umfasst, wobei das Leistungshalbleiterelement über den Leadframe auf der dielektrischen Materiallage kontaktiert wird, wobei eine Bondverbindung zwischen dem Steuerkontakt, insbesondere Gate-Kontakt, des Leistungshalbleiters und dem dritten metallischen Kontaktierungselement des Leadframes hergestellt wird, wobei das erste metallische Kontaktierungselement und das dritte metallische Kontaktierungselement jeweils mittels einer orthogonal zur Oberfläche des Kühlelements wirkenden Kraft fixiert werden und wobei die Verbindung zwischen dem ersten metallischen Kontaktierungselement und dem dritten metallischen Kontaktierungselement des Leadframes aufgetrennt wird. Unter einem Leadframe ist in diesem Fall ein strukturiertes Metallplättchen zu verstehen, wobei die Strukturierung beispielsweise über Stanzen oder Laserschneiden hergestellt ist. Der Leadframe umfasst das erste metallische Kontaktierungselement und das dritte metallische Kontaktierungselement, die durch zumindest einen metallischen Steg miteinander verbunden sind, wobei eine Stegbreite schmaler als eine Breite des ersten metallischen Kontaktierungselements und des dritten metallischen Kontaktierungselements ist. Insbesondere mittels Laser oder durch mechanische Bearbeitung, beispielsweise Schneiden, wird der zumindest eine Steg zwischen dem ersten metallischen Kontaktierungselement und dem dritten metallischen Kontaktierungselement durchtrennt. Da das erste metallische Kontaktierungselement und das dritte metallische Kontaktierungselement während der Herstellung jeweils vor dem Durchtrennen des zumindest einen Steges durch Kraftschluss fixiert werden, ist ein derartiges Herstellungsverfahren sowohl einfach als auch zuverlässig.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführung eines Leistungshalbleitermoduls,
- FIG 2: eine schematische Darstellung einer zweiten Ausführung eines Leistungshalbleitermoduls,
- FIG 3: eine schematische Darstellung einer dritten Ausführung eines Leistungshalbleitermoduls,
- FIG 4: eine schematische Darstellung einer vierten Ausführung eines Leistungshalbleitermoduls,
- FIG 5: eine schematische Darstellung einer fünften Ausführung eines Leistungshalbleitermoduls,
- FIG 6: eine schematische Darstellung einer sechsten Ausführung eines Leistungshalbleitermoduls und
- FIG 7: eine schematische Darstellung eines Verfahrens zur Herstellung eines Leistungshalbleitermoduls.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

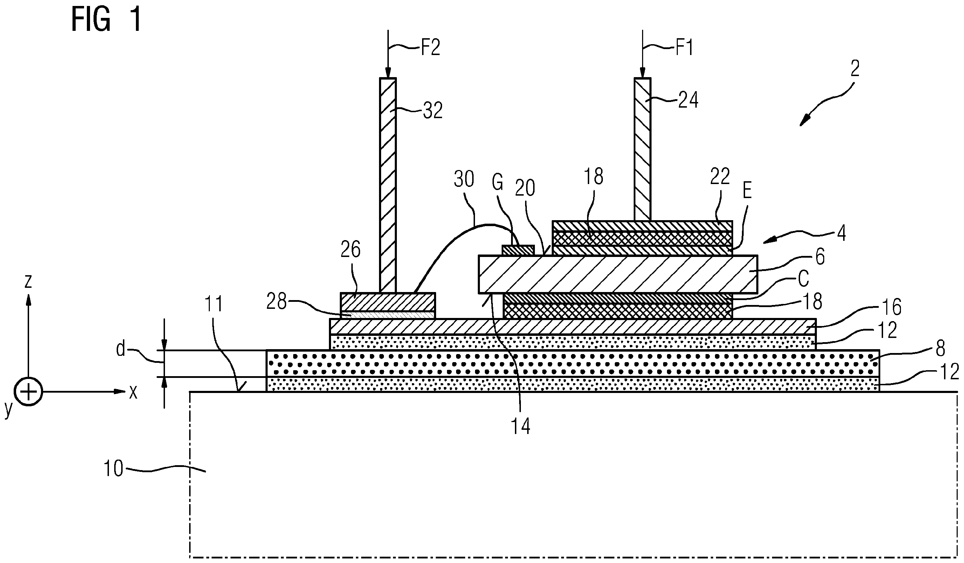

FIG 1 zeigt eine schematische Darstellung einer ersten Ausführung eines Leistungshalbleitermoduls 2 mit einem Leistungshalbleiterelement 4, das einen Leistungshalbleiter 6 aufweist und einer dielektrischen Materiallage 8, die mit einem Kühlelement 10 in einer elektrisch isolierenden und thermisch leitfähigen Verbindung steht. Das Kühlelement 10 ist insbesondere als Kühlkörper ausgeführt, der beispielweise aus Aluminium und/oder Kupfer hergestellt ist und für freie Konvektion und/oder forcierte Luftkühlung geeignet ist. Die dielektrische Materiallage 8 weist einen keramischen Werkstoff, beispielsweise Aluminiumnitrid oder Aluminiumoxid, oder einen organischen Werkstoff, beispielsweise ein Polyamid, auf und liegt flächig auf einer Oberfläche 11 des Kühlelements 10 auf. Beispielsweise beträgt eine Dicke d der dielektrischen Materiallage 8 25 µm bis 400 µm, insbesondere 50 µm bis 250 µm. Somit steht das Leistungshalbleiterelement 4 über die dielektrische Materiallage 8 mit der Oberfläche 11 des Kühlelements 10 in einer elektrisch isolierenden und thermisch leitfähigen Verbindung. Insbesondere ist die dielektrische Materiallage 8 mittels Wärmeleitpaste 12 schwimmend auf der Oberfläche 11 des Kühlelements 10 kontaktiert. Die Wärmeleitpaste 12 wird möglichst dünn aufgetragen. Beispielsweise wird eine Wärmeleitpaste 12 verwendet, die sehr kleine Partikel, insbesondere mit einer Partikelgröße im Bereich von 0,04 µm bis 4 µm aufweist. Die Oberfläche 11 des Kühlelements 10 definiert eine x-y-Ebene sowie eine z-Richtung.

Der Leistungshalbleiter 6 ist beispielhaft als IGBT ausgeführt und weist auf einer der dielektrischen Materiallage 8 zugewandten Seite 14 einen Kollektor-Kontakt C auf. Der Kollektor-Kontakt C ist stoffschlüssig mit einem ersten metallischen Kontaktierungselement 16 verbunden, das beispielsweise aus Kupfer hergestellt ist. Die stoffschlüssige Verbindung wird über eine elektrisch und thermisch leitfähige Verbindungsmasse 18 durch z.B. Löten oder Sintern hergestellt. Das Leistungshalbleiterelement 4 liegt über das erste metallische Kontaktierungselement 16 schwimmend auf der dielektrischen Materiallage 8 auf, wobei durch Wärmeleitpaste 12 zwischen dem ersten metallischen Kontaktierungselement 16 und der dielektrischen Materiallage 8 eine elektrisch isolierende und thermisch leitfähige Verbindung besteht.

Der beispielhaft als IGBT ausgeführte Leistungshalbleiter 6 weist auf einer der dielektrischen Materiallage 8 abgewandten Seite 20 einen Emitter-Kontakt E und einen Gate-Kontakt G auf, wobei ein zweites metallisches Kontaktierungselement 22, das beispielsweise aus Kupfer hergestellt ist, stoffschlüssig mit dem Emitter-Kontakt E des Leistungshalbleiters 6 verbunden ist. Die stoffschlüssige Verbindung wird über eine elektrisch und thermisch leitfähige Verbindungsmasse 18 z.B. durch Löten oder Sintern hergestellt. Eine erste Kraft F1 wird über eine erste Stromschiene 24, die orthogonal zur x-y-Ebene angeordnet ist, auf das zweite metallische Kontaktierungselement 22 übertragen. Über die erste Kraft F1 werden das Leistungshalbleiterelement 4 auf die dielektrischen Materiallage 8 und die dielektrische Materiallage 8 auf die Oberfläche 11 des Kühlelements 10 gepresst, sodass das Leistungshalbleiterelement 4 mit der dielektrischen Materiallage 8 und die dielektrische Materiallage 8 mit dem Kühlelements 10 kraftschlüssig verbunden sind.

Ein drittes metallisches Kontaktierungselement 26 ist über eine, insbesondere geklebte, Isolation 28 mit dem ersten metallischen Kontaktierungselement 16, insbesondere adhäsiv, verbunden, wobei der Gate-Kontakt G des Leistungshalbleiters 4 über eine Bondverbindung 30 mit dem dritten metallischen Kontaktierungselement 26 kontaktiert ist. Ferner wird das dritte metallische Kontaktierungselement 26 mittels einer parallel zur ersten Kraft F1 wirkenden zweiten Kraft F2, die über eine zweite Stromschiene 32 übertragen wird, auf das erste metallische Kontaktierungselement 16 gepresst.

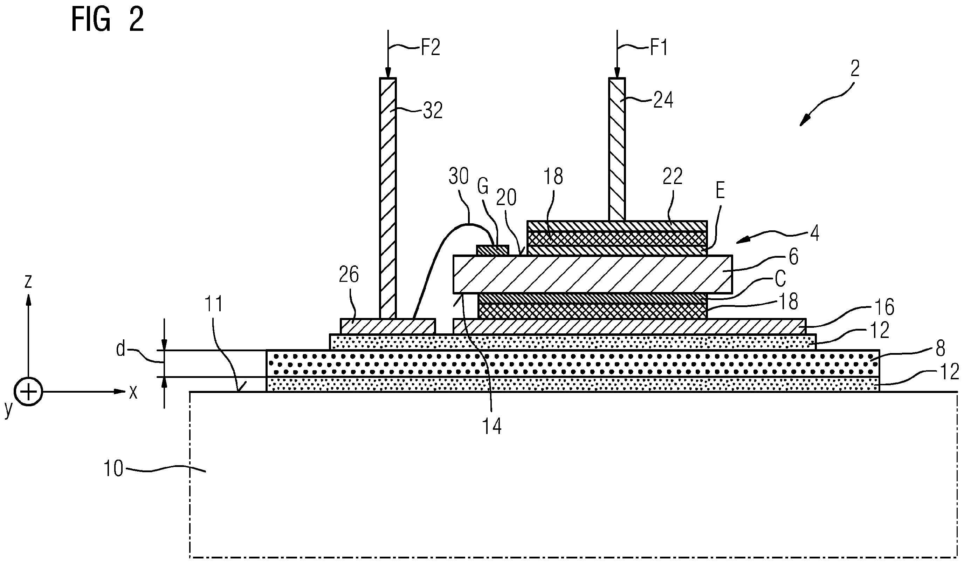

FIG 2 zeigt eine schematische Darstellung einer zweiten Ausführung eines Leistungshalbleitermoduls 2. Das dritte metallische Kontaktierungselement 26 wird mit der zweiten Kraft F2 über die zweite Stromschiene 32 auf die dielektrische Materiallage 8 gepresst, wobei durch Wärmeleitpaste 12 zwischen dem dritten metallischen Kontaktierungselement 26 und der dielektrischen Materiallage 8 eine elektrisch isolierende und thermisch leitfähige Verbindung besteht. Die weitere Ausführung des Leistungshalbleitermoduls 2 in FIG 2 entspricht der Ausführung in FIG 1.

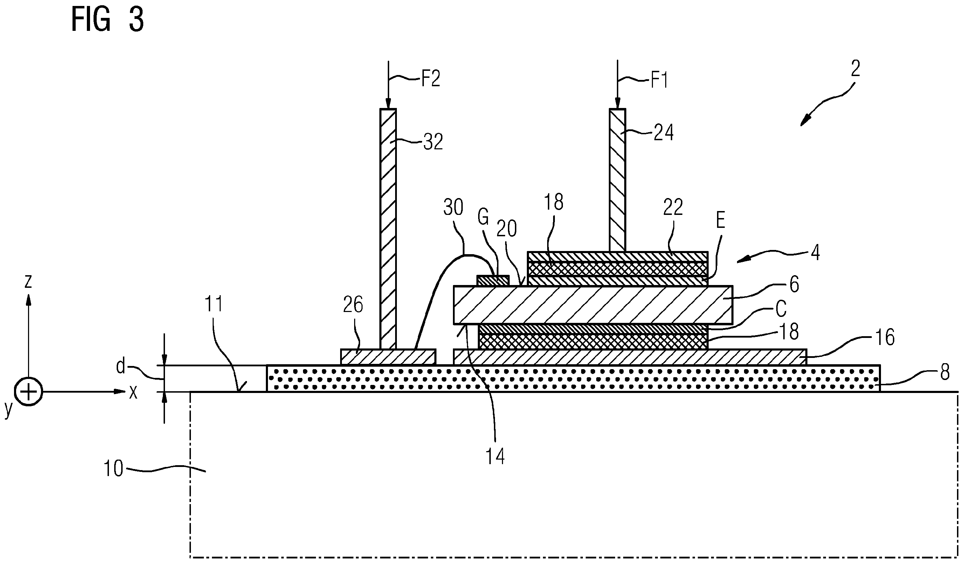

FIG 3 zeigt eine schematische Darstellung einer dritten Ausführung eines Leistungshalbleitermoduls 2. Die dielektrische Materiallage 8 ist unmittelbar mit der Oberfläche 11 des Kühlelements 10 kontaktiert. Eine unmittelbare Kontaktierung schließt in diesem Zusammenhang zusätzliche Verbindungsmittel wie Kleber, Lötzinn, Wärmeleitpaste, ... aus. Darüber hinaus ist das erstes metallisches Kontaktierungselement 16 des Leistungshalbleiterelements 4 unmittelbar mit der dielektrischen Materiallage 8 kontaktiert. Die dielektrische Materiallage 8 kann als geklebte Isolation aus einem organischen Werkstoff, beispielsweise ein Polyamid, ausgeführt sein. Durch eine derartige geklebte Isolation ist eine adhäsive Verbindung zwischen dem Leistungshalbleiterelement 4 und der Oberfläche 11 des Kühlelements 10 herstellbar. Durch Anpressen mittels Stromschienen 24, 32 steht das Leistungshalbleiterelement 4 über die dielektrische Materiallage 8 mit der Oberfläche 11 des Kühlelements 10 in einer elektrisch isolierenden und thermisch leitfähigen Verbindung. Die weitere Ausführung des Leistungshalbleitermoduls 2 in FIG 3 entspricht der Ausführung in FIG 2.

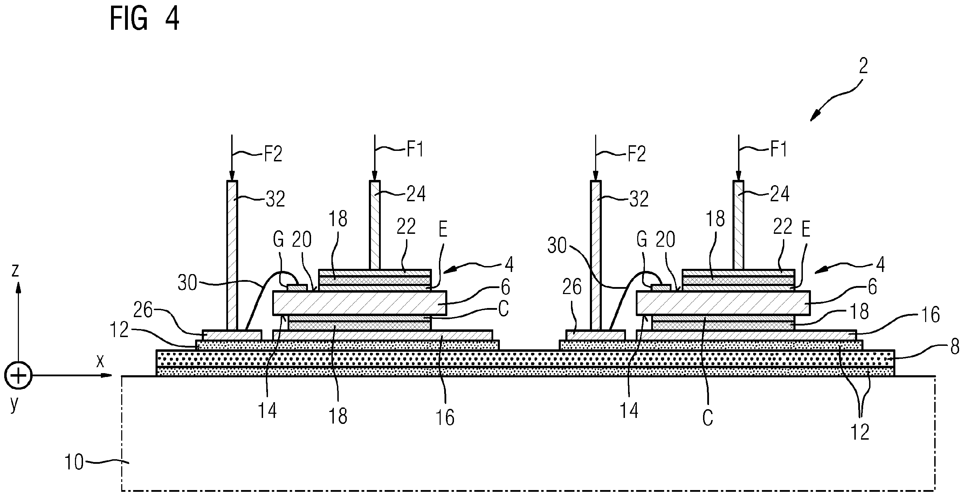

FIG 4 zeigt eine schematische Darstellung einer vierten Ausführung eines Leistungshalbleitermoduls 2, das beispielhaft zwei Leistungshalbleiterelemente 4 aufweist. Den zwei Leistungshalbleiterelementen 4 ist eine gemeinsame dielektrische Materiallage 8 zugewiesen. Das Leistungshalbleitermodul 2 kann auch mehr als zwei Leistungshalbleiterelemente 4 aufweisen, denen eine gemeinsame dielektrische Materiallage 8 zugewiesen ist.

Die Leistungshalbleiterelemente 4 liegen jeweils über ein erstes metallische Kontaktierungselement 16 schwimmend auf der gemeinsamen dielektrischen Materiallage 8 auf. Durch Wärmeleitpaste 12 zwischen dem jeweiligen ersten metallischen Kontaktierungselement 16 und der gemeinsamen dielektrischen Materiallage 8 wird eine elektrisch isolierende und thermisch leitfähige Verbindung hergestellt. Ferner ist die gemeinsame dielektrische Materiallage 8 mittels Wärmeleitpaste 12 schwimmend auf der Oberfläche 11 des Kühlelements 10 kontaktiert. Durch Anpressen mittels Stromschienen 24, 32 stehen die Leistungshalbleiterelemente 4 über die gemeinsame dielektrische Materiallage 8 mit der Oberfläche 11 des Kühlelements 10 in einer elektrisch isolierenden und thermisch leitfähigen Verbindung.

Es können die ersten metallischen Kontaktierungselemente 16 des jeweiligen Leistungshalbleiterelements 4 auch unmittelbar mit der gemeinsamen dielektrischen Materiallage 8 kontaktiert sein, und/oder es kann auch die gemeinsame dielektrische Materiallage 8 unmittelbar mit der Oberfläche 11 des Kühlelements 10 kontaktiert sein, wobei durch Anpressen eine elektrisch isolierende und thermisch leitfähige Verbindung hergestellt wird. Die weitere Ausführung des Leistungshalbleitermoduls 2 in FIG 4 entspricht der Ausführung in FIG 2.

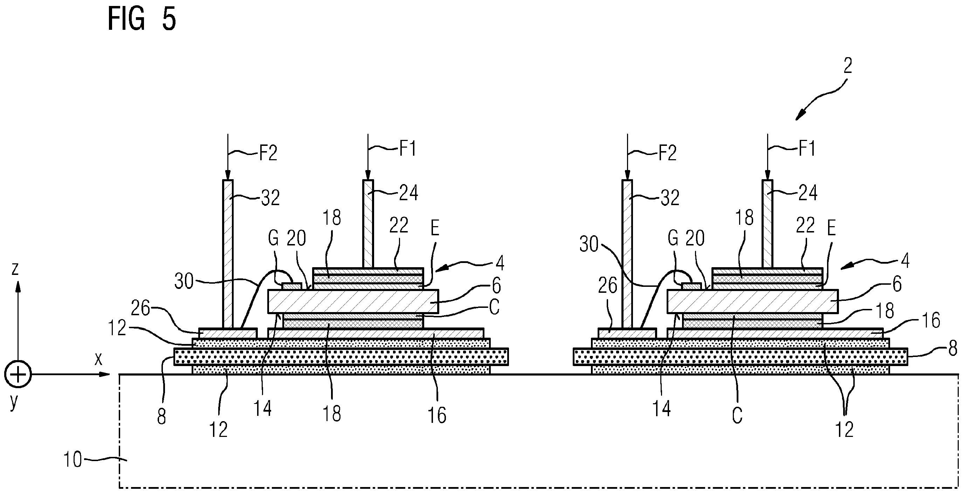

FIG 5 zeigt eine schematische Darstellung einer fünften Ausführung eines Leistungshalbleitermoduls 2, das beispielhaft zwei Leistungshalbleiterelemente 4 aufweist. Jedem der zwei Leistungshalbleiterelemente 4 ist eine dedizierte dielektrische Materiallage 8 zugewiesen. Das Leistungshalbleitermodul 2 kann auch mehr als zwei Leistungshalbleiterelemente 4 aufweisen, denen jeweils eine dedizierte dielektrische Materiallage 8 zugewiesen ist. Die weitere Ausführung des Leistungshalbleitermoduls 2 in FIG 5 entspricht der Ausführung in FIG 4.

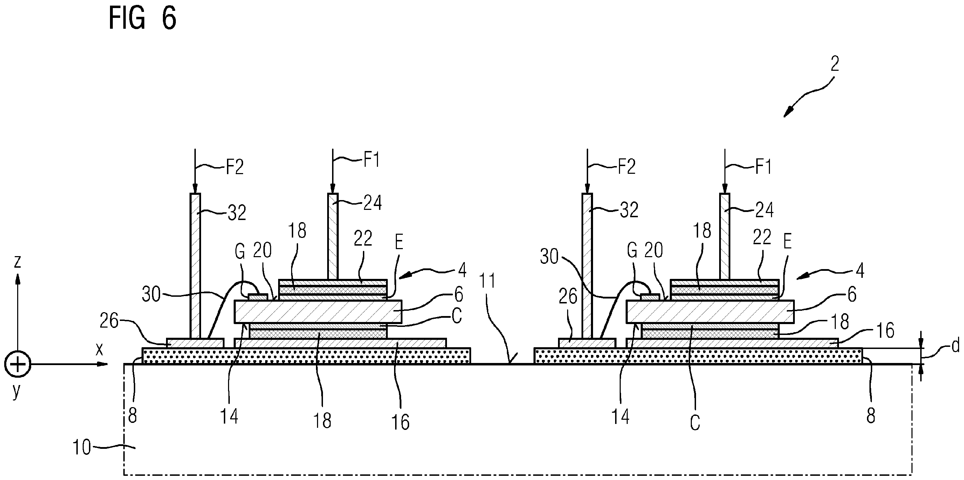

FIG 6 zeigt eine schematische Darstellung einer sechsten Ausführung eines Leistungshalbleitermoduls 2, das beispielhaft zwei Leistungshalbleiterelemente 4 aufweist. Jedem der zwei Leistungshalbleiterelemente 4 ist eine dedizierte dielektrische Materiallage 8 zugewiesen, wobei die ersten metallischen Kontaktierungselemente 16 des jeweiligen Leistungshalbleiterelements 4 unmittelbar mit der dedizierten dielektrischen Materiallage 8 kontaktiert sind. Ferner sind die dielektrischen Materiallagen 8 jeweils unmittelbar mit der Oberfläche 11 des Kühlelements 10 kontaktiert. Die weitere Ausführung des Leistungshalbleitermoduls 2 in FIG 6 entspricht der Ausführung in FIG 3.

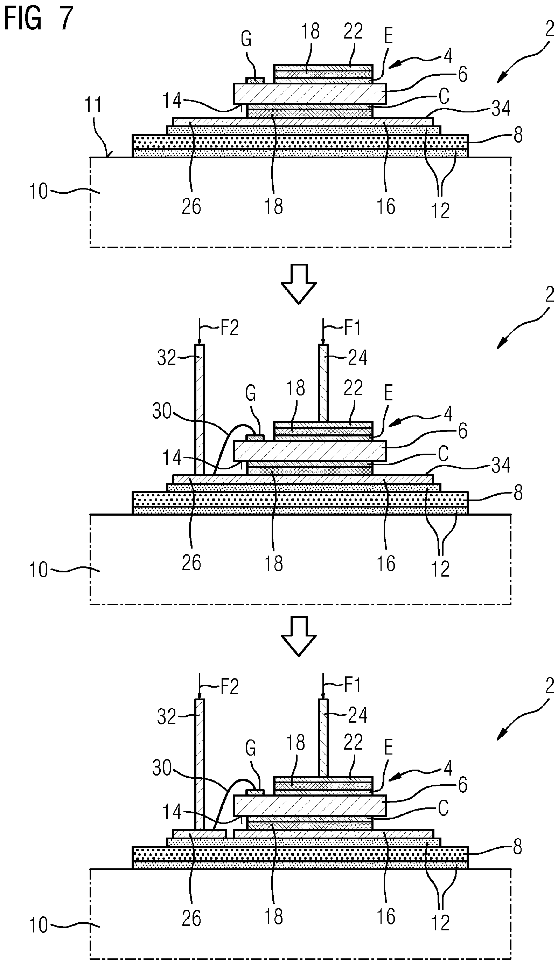

FIG 7 zeigt eine schematische Darstellung eines Verfahrens zur Herstellung eines Leistungshalbleitermoduls 2. Es wird die dielektrische Materiallage 8 flächig mit der Oberfläche 11 des Kühlelements 10 kontaktiert. Darüber hinaus wird zur Bildung des Leistungshalbleiterelements 4 der Kollektor-Kontakt C des beispielhaft als IGBT ausgeführten Leistungshalbleiters 6 stoffschlüssig mit einem Leadframe 34 verbunden, wobei der Leadframe 34 das erste metallische Kontaktierungselement 16 und das dritte metallische Kontaktierungselement 26, welches mit dem ersten metallischen Kontaktierungselement 16 verbunden ist, umfasst. Ferner wird das zweite metallische Kontaktierungselement 22 stoffschlüssig mit dem Emitter-Kontakt E des Leistungshalbleiters 6 verbunden und das Leistungshalbleiterelement 4 über den Leadframe 34 auf der dielektrischen Materiallage 8 kontaktiert.

In einem darauffolgenden Schritt wird eine Bondverbindung 30 zwischen dem Gate-Kontakt G, des Leistungshalbleiters 6 und dem dritten metallischen Kontaktierungselement 26 des Leadframes 34 hergestellt. Das erste metallische Kontaktierungselement 16 und das dritte metallische Kontaktierungselement 26 werden jeweils mittels einer orthogonal zur Oberfläche 11 des Kühlelements 10 wirkenden Kraft F1, F2 fixiert.

In einem darauffolgenden Schritt wird die Verbindung zwischen dem ersten metallischen Kontaktierungselement 16 und dem dritten metallischen Kontaktierungselement 26 des Leadframes 34 aufgetrennt. Das Auftrennen der Verbindung erfolgt beispielsweise mittels Laser oder durch mechanische Bearbeitung. Die weitere Ausführung des Leistungshalbleitermoduls 2 in FIG 7 entspricht beispielhaft der Ausführung in FIG 2. Die Herstellung der anderen Ausführungsformen erfolgt analog.

Zusammenfassend betrifft die Erfindung ein Leistungshalbleitermodul 2 mit zumindest einem Leistungshalbleiterelement 4. Um den erforderlichen Bauraum des Leistungshalbleitermoduls 2 zu verringern und dessen Lebensdauer zu erhöhen, wird vorgeschlagen, dass das zumindest eine Leistungshalbleiterelement 4 über eine dielektrische Materiallage 8 mit einem Kühlelement 10 in einer elektrisch isolierenden und thermisch leitfähigen Verbindung steht, wobei die dielektrische Materiallage 8 flächig auf einer Oberfläche 11 des Kühlelements 10 aufliegt und mittels einer orthogonal zur Oberfläche 11 des Kühlelements 10 wirkenden ersten Kraft F1 kraftschlüssig mit dem Kühlelement 10 verbunden ist.

## Patentansprüche

1. Leistungshalbleitermodul (2) mit zumindest einem Leistungshalbleiterelement (4),
wobei das zumindest eine Leistungshalbleiterelement (4) über eine dielektrische Materiallage (8) mit einem Kühlelement (10) in einer elektrisch isolierenden und thermisch leitfähigen Verbindung steht,
wobei die dielektrische Materiallage (8) flächig auf einer Oberfläche (11) des Kühlelements (10) aufliegt und
mittels einer orthogonal zur Oberfläche (11) des Kühlelements (10) wirkenden ersten Kraft (F1) kraftschlüssig mit dem Kühlelement (10) verbunden ist.

2. Leistungshalbleitermodul (2) nach Anspruch 1,
wobei die dielektrische Materiallage (8) unmittelbar oder mittels Wärmeleitpaste (12) schwimmend auf dem Kühlelement (10) kontaktiert ist.

3. Leistungshalbleitermodul (2) nach einem der Ansprüche 1 oder 2,
wobei die erste Kraft (F1) über eine erste Stromschiene (24) auf das Leistungshalbleiterelement (4) übertragen wird.

4. Leistungshalbleitermodul (2) nach einem der vorherigen Ansprüche,
wobei die dielektrische Materiallage (8) eine adhäsive Verbindung zwischen dem Leistungshalbleiterelement (4) und der Oberfläche (11) des Kühlelements (10) herstellt.

5. Leistungshalbleitermodul (2) nach einem der vorherigen Ansprüche,
aufweisend mindestens zwei Leistungshalbleiterelemente (4), wobei jedem der mindestens zwei Leistungshalbleiterelemente (4) eine dedizierte dielektrische Materiallage (8) zugewiesen ist.

6. Leistungshalbleitermodul (2) nach einem der vorherigen Ansprüche,
wobei das Leistungshalbleiterelement (4) einen Leistungshalbleiter (6) aufweist, der auf einer der dielektrische Materiallage (8) zugewandten Seite (14) stoffschlüssig mit einem ersten metallischen Kontaktierungselement (16) verbunden ist, wobei das das Leistungshalbleiterelement (4) über das erste metallische Kontaktierungselement (16) auf der dielektrischen Materiallage (8) aufliegt und
durch die erste Kraft (F1) kraftschlüssig mit der dielektrischen Materiallage (8) verbunden ist.

7. Leistungshalbleitermodul (2) nach Anspruch 6,
wobei das erste metallische Kontaktierungselement (16) unmittelbar oder mittels Wärmeleitpaste (12) schwimmend auf der dielektrischen Materiallage (8) kontaktiert ist.

8. Leistungshalbleitermodul (2) nach einem der vorherigen Ansprüche,
wobei zumindest ein zweites metallisches Kontaktierungselement (22) auf einer der dielektrischen Materiallage (8) abgewandten Seite (20) des Leistungshalbleiters (6) flächig mit dem Leistungshalbleiter (6) verbunden ist,
wobei die erste Stromschiene (24) unmittelbar mit dem zweiten metallischen Kontaktierungselement (22) kontaktiert ist, wobei die erste Kraft (F1) über die erste Stromschiene (24) auf das zweite metallische Kontaktierungselement (22) wirkt.

9. Leistungshalbleitermodul (2) nach Anspruch 8,
wobei das zweite metallische Kontaktierungselement (22) stoffschlüssig mit dem Leistungshalbleiter (6) verbunden ist.

10. Leistungshalbleitermodul (2) nach einem der Ansprüche 8 oder 9,
wobei die erste Stromschiene (24) kraftschlüssig mit dem zweiten metallischen Kontaktierungselement (22) verbunden ist.

11. Leistungshalbleitermodul (2) nach einem der vorherigen Ansprüche,
wobei ein Steuerkontakt, insbesondere ein Gate-Kontakt (G), des Leistungshalbleiters (6), insbesondere über eine Bondverbindung (30), mit einem dritten metallischen Kontaktierungselement (26) verbunden ist,
wobei das dritte metallische Kontaktierungselement (26) mittels einer orthogonal zur Oberfläche (11) des Kühlelements (10) wirkenden zweiten Kraft (F2) kraftschlüssig mit dem Kühlelement (10) verbunden ist.

12. Leistungshalbleitermodul (2) nach Anspruch 11,
wobei die zweite Kraft (F2) über eine zweite Stromschiene (32) auf das dritte metallische Kontaktierungselement (26) wirkt.

13. Stromrichter mit mindestens einem Leistungshalbleitermodul (2) nach einem der Ansprüche 1 bis 12.

14. Verfahren zur Herstellung eines Leistungshalbleitermoduls (2) nach einem der Ansprüche 1 bis 12,
wobei die dielektrische Materiallage (8) flächig mit der Oberfläche (11) des Kühlelements (10) kontaktiert wird, wobei das Leistungshalbleiterelement (4) auf der dielektrischen Materiallage (8) kontaktiert wird und
wobei mittels der orthogonal zur Oberfläche (11) des Kühlelements (10) wirkenden ersten Kraft (F1) eine kraftschlüssige Verbindung zum Kühlelement (10) hergestellt wird.

15. Verfahren nach Anspruch 14,
wobei das Leistungshalbleiterelement (4) durch Herstellung einer stoffschlüssigen Verbindung des Leistungshalbleiters (6) mit einem Leadframe (34) gebildet wird,
wobei der Leadframe (34) das erste metallische Kontaktierungselement (16) und das dritte metallische Kontaktierungselement (26), welches mit dem ersten metallischen Kontaktierungselement (16) verbunden ist, umfasst,
wobei das Leistungshalbleiterelement (4) über den Leadframe (34) auf der dielektrischen Materiallage (8) kontaktiert wird,
wobei eine Bondverbindung (30) zwischen dem Steuerkontakt, insbesondere Gate-Kontakt (G), des Leistungshalbleiters (6) und dem dritten metallischen Kontaktierungselement (26) des Leadframes (34) hergestellt wird,
wobei das erste metallische Kontaktierungselement (16) und das dritte metallische Kontaktierungselement (26) jeweils mittels einer orthogonal zur Oberfläche (11) des Kühlelements (10) wirkenden Kraft (F1, F2) fixiert werden und
wobei die Verbindung zwischen dem ersten metallischen Kontaktierungselement (16) und dem dritten metallischen Kontaktierungselement (26) des Leadframes (34) aufgetrennt wird.
